(19) Europäisches Patentamt / European Patent Office / Office européen des brevets

(11) **EP 4 198 545 A1**

(12) **EUROPEAN PATENT APPLICATION**

(43) Date of publication:
**21.06.2023 Bulletin 2023/25**

(21) Application number: **21214552.8**

(22) Date of filing: **14.12.2021**

(51) International Patent Classification (IPC):
**G01R 33/48** (2006.01)     **G01R 33/56** (2006.01)
**G01R 33/565** (2006.01)     G06N 3/02 (2006.01)

(52) Cooperative Patent Classification (CPC):
**G01R 33/4828; G01R 33/4818; G01R 33/5608;
G01R 33/56527;** G01R 33/56563; G06N 3/02

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Siemens Healthcare GmbH
91052 Erlangen (DE)**

(72) Inventor: **Nickel, Marcel Dominik
91074 Herzogenaurach (DE)**

(54) **CHEMICAL SHIFT CORRECTION FOR MULTI-POINT MAGNETIC RESONANCE MEASUREMENTS**

(57)     Various examples of the disclosure relate to an optimization to obtain spin-species specific magnetic resonance images, such as to perform water-fat separation, the optimization using a target function that calculates a dephasing of a second spin species with respect to the first spin species based on a sampling trajectory of a respective measurement protocol.

# FIG 3

**Description**

TECHNICAL FIELD

Various examples of the disclosure generally relate to magnetic resonance imaging (MRI) to determine MRI images having contrasts associated with different spins species. Various examples facilitate determining the MRI images with reduced chemical shift artifacts.

BACKGROUND

Based on MRI data acquired using appropriate MRI measurement protocols, it is possible to separate different spectral components of the MRI data. The different spectral components can be associated with different spin species, e.g., nuclear spins in a fat environment and other nuclear spins in a water environment. Oftentimes, the chemical shift between hydrogen nuclear spins in water as a first spin species and hydrogen nuclear spins in fatty acids as a second spin species is considered (simply water and fat spin species hereinafter). For this, conventionally, chemical-shift-imaging multipoint MRI measurement sequences are employed. Such techniques typically are based on the effect of the resonance frequency of nuclear spins depending on the molecular/chemical environment. This effect is labeled chemical shift. Various spin species thus exhibit different resonance frequencies. For instance, a difference between two resonance frequencies can be expressed in terms of parts per million (ppm). For example, the main fat peak oscillates at a frequency that is -3.4ppm next to that of the water protons.

For water-fat separation, a water MRI image can be determined having a contrast that is affected by water spins (but not or only to a limited degree by fat spins); and a fat MRI image can be determined having a contrast that is affected by fat spins (but not, or only to a limited degree, by water spins).

To separate the spectral components, MRI data is acquired at multiple echo times. The echo time in this context refers to a time offset relative to a timepoint for which water and fat - or generally the different spin species - are aligned, i.e., the magnetization points into the same direction. In particular, for spin-echo sequences, such time offset can also take negative values. In this case, the contrast refers to a timepoint before refocusing water and fat signals are aligned.

Generally, the time evolution of MRI data (MRI signals) associated with different spin species exhibit different phase offsets at different echo times, due to the chemical shift. This effect can be exploited to separate the MRI signals and determine respective MRI images.

According to reference implementations, a signal model is used which models the MRI signals based on various physical parameters such as the water and fat contribution to a respective pixel/voxel (hereinafter, the term pixel is intended to embrace 3-D structures such as voxels). These physical parameters can, depending on the complexity of the signal model, encompass additional properties of the measurement system, specifically various imperfections affecting the reference value of the phase (simply, reference phase). A respective phase map can be considered. The phase map of the signal model can describe the spatial evolution of the reference phase of the MRI data due to the polarizing magnetic field being inhomogeneous and/or due to use of bipolar readout gradient fields of the measurement protocol used for creating gradient echoes at the multiple echo times.

The signal model can be fitted to the time evolution of the MRI data, thereby finding parameter values for the physical parameters and specifically separating water and fat contributions to the MRI signal

Depending on a particular post-processing technique, the implementation of the signal model can vary. For instance, conventional Dixon processing would not consider the chemical shifts going into opposite directions for the different polarities of a bipolar readout train of the measurement protocol; this would lead to so-called chemical shift artifacts such as artificial lines at tissue borders. The same applies to non-Cartesian acquisitions for which the chemical shift leads to a convolution of the fat signal, typically resulting in off-resonance blurring.

The following prior art is known: DE 10 2013 217 654 A1 and US 2020 049 783 A and US 7777486 B2 and US 8605967 B2.

SUMMARY

Accordingly, a need exists for advanced techniques of determining MRI images having different contrasts associated with different spin species. Specifically, a need exists for techniques of determining MRI images with reduced chemical shift artifacts.

This need is met by the features of the independent claims. The features of the dependent claims define embodiments.

A computer-implemented method for determining a first MRI image having a first contrast associated with a first spin species and a second image having a second contrast that is associated with a second spin species is provided. The computer-implemented method includes obtaining multiple MRI images that are acquired for multiple echo times using a measurement protocol. Each one of the multiple MRI images includes a contrast that is associated with both the first spin species as well as the second spin species. Based on the multiple MRI images, an optimization is performed to determine the first MRI image for the first spin species and the second MRI image for the second spin species. The optimization includes a target function that calculates, based on a sampling trajectory of the measurement protocol, a dephasing of the second spin species with respect to the first spin species as a function of time. Further, the target function of the optimization takes into account in image-based regularization operation.

A computer program includes program code for determining a first MRI image having a first contrast that is associated with a first spin species and a second MRI image having a second contrast associated with a second spin species. The program code causes a processor that executes the program code to obtain multiple MRI images that are acquired for multiple echo times using a measurement protocol. Each one of the multiple MRI images includes a contrast that is associated with both the first spin species as well as the second spin species. Based on the multiple MRI images, an optimization is performed to determine the first MRI image for the first spin species and the second MRI image for the second spin species. The optimization includes a target function that calculates, based on a sampling trajectory of the measurement protocol, a dephasing of the second spin species with respect to the first spin species as a function of time. Further, the target function of the optimization takes into account in image-based regularization operation.

A device includes a processor and a memory. The processor can load program code from the memory and execute the program code. The program code is for determining a first MRI image having a first contrast that is associated with a first spin species and a second MRI image having a second contrast associated with a second spin species. The program code causes the processor that executes the program code to obtain multiple MRI images that are acquired for multiple echo times using a measurement protocol. Each one of the multiple MRI images includes a contrast that is associated with both the first spin species as well as the second spin species. Based on the multiple MRI images, an optimization is performed to determine the first MRI image for the first spin species and the second MRI image for the second spin species. The optimization includes a target function that calculates, based on a sampling trajectory of the measurement protocol, a dephasing of the second spin species with respect to the first spin species as a function of time. Further, the target function of the optimization takes into account in image-based regularization operation.

It is to be understood that the features mentioned above and those yet to be explained below may be used not only in the respective combinations indicated, but also in other combinations or in isolation without departing from the scope of the invention.

## BRIEF DESCRIPTION OF THE DRAWINGS

FIG. 1 schematically illustrates an MRI device according to various examples.

FIG. 2 schematically illustrates a flowchart of a method according to various examples.

FIG. 3 schematically illustrates a bipolar gradient-echo readout train of a measurement protocol used to acquire MRI data according to various examples.

## DETAILED DESCRIPTION OF EMBODIMENTS

Some examples of the present disclosure generally provide for a plurality of circuits or other electrical devices. All references to the circuits and other electrical devices and the functionality provided by each are not intended to be limited to encompassing only what is illustrated and described herein. While particular labels may be assigned to the various circuits or other electrical devices disclosed, such labels are not intended to limit the scope of operation for the circuits and the other electrical devices. Such circuits and other electrical devices may be combined with each other and/or separated in any manner based on the particular type of electrical implementation that is desired. It is recognized that any circuit or other electrical device disclosed herein may include any number of microcontrollers, a graphics processor unit (GPU), integrated circuits, memory devices (e.g., FLASH, random access memory (RAM), read only memory (ROM), electrically programmable read only memory (EPROM), electrically erasable programmable read only memory (EEPROM), or other suitable variants thereof), and software which co-act with one another to perform operation(s) disclosed herein. In addition, any one or more of the electrical devices may be configured to execute a program code that is embodied in a non-transitory computer readable medium programmed to perform any number of the functions as disclosed.

In the following, embodiments of the invention will be described in detail with reference to the accompanying drawings. It is to be understood that the following description of embodiments is not to be taken in a limiting sense. The scope of the invention is not intended to be limited by the embodiments described hereinafter or by the drawings, which are taken to be illustrative only.

The drawings are to be regarded as being schematic representations and elements illustrated in the drawings are not necessarily shown to scale. Rather, the various elements are represented such that their function and general purpose become apparent to a person skilled in the art. Any connection or coupling between functional blocks, devices, components, or other physical or functional units shown in the drawings or described herein may also be implemented by an indirect connection or coupling. A coupling between components may also be established over a wireless connection. Functional blocks may be implemented in hardware, firmware, software, or a combination thereof.

Hereinafter, techniques are disclosed that facilitate separating multiple spectral components included in MRI signals. Multiple MRI images can be determined having contrasts associated with respective spin species. A first spin species may be fat, and a second spin species may be water. However, as a general rule, arbitrary spin species can be separated, e.g., nuclear spins in a silicon environment, etc. It would also be possible to separate spectral components for more than two spin species. Nonetheless, hereinafter, for sake of simplicity, reference will be made to water and fat separation.

According to examples of the disclosure, an MRI water image and an MRI fat image are determined.

According to various examples, this is based on performing an optimization to determine the MRI water image and the MRI fat image. The optimization finds an extreme value for a target function that calculates a dephasing of the two spin species - i.e., water and fat - with respect to each other. In other words, the chemical shift between the two spin species can be taken into account. This dephasing is calculated considering the respective readout time at which a data sample of the MRI is acquired. The readout time is defined by the sampling trajectory of the measurement protocol. Accordingly, the optimization can be based on a target function that calculates, based on the sampling trajectory of the measurement protocol, the dephasing of the water with respect to the fat.

The optimization operates based on multiple MRI images that are acquired for multiple echo times using a respective multi-point measurement protocol. These MRI images will be referred to as MRI echo images hereinafter. Each one of the multiple MRI images includes a contrast that is associated with a superposition of the signal contributions of water spin species and the fat spin species at the respective echo time. In further detail: MRI data is acquired using a multipoint MRI measurement sequence. I.e., MRI data are acquired for multiple echo times. These echo times denote the offset to a reference timing at which the multiple spin species do not exhibit a phase offset.

As a general rule, a two-point measurement protocol could be used. Here, the count of echo times is not larger than 2. This is based on the finding that even for a comparably small number of MRI echo images, accurate determination of MRI water image an MRI fat image is possible using the techniques disclosed herein.

For instance, a gradient echo sequence such as the one described by the following reference could be used: X. Zhong, M. D. Nickel, S. A. Kannengiesser, B. M. Dale, B. Kiefer, and M. R. Bashir, "Liver fat quantication using a multi-step adaptive fitting approach with multi-echo GRE imaging," Magn. Reson. Med., vol. 72, no. 5, pp. 1353-1365, 2014.

The measurement protocol, in some examples, includes a bipolar gradient echo readout train. This means that subsequent gradient echoes are formed using gradient pulses having opposing directions (i.e., different polarities).

Each raw data sample is sampled by monitoring the nuclear spin signal during a readout duration at the respective echo time. Typical readout durations are 1-3ms, also depending on the magnetic field strengths.

Using a reconstruction algorithm, the raw data can be transformed into MRI echo images. A Fourier transform from k-space to image domain can be used. Undersampling could be used, e.g., using parallel acquisition techniques where multiple receiver coils are employed. Reconstruction of MRI (echo) images based on raw data is generally well known and the particular reconstruction algorithm employed is not germane for the functioning of the techniques described herein.

Some aspects of the disclosure are based on the finding that the effects of the chemical shift due to the k-space trajectory are equally present in reconstructed, coil-combined images. Therefore, the reconstructed images can be transformed into the Fourier domain, i.e., a synthesized, effective k-space for a single-coil acquisition. The k-space trajectory can also be translated into this "effective" k-space and used for the present disclosure.

The signals of different spin species evolve differently as a function of time, i.e., during the readout duration and along the multiple echo times. These dependencies are captured by the signal model describing the evolution of the overall signal as a function of time. For instance, the following signal model can be used:

$$S_E(x,t) = \big(W(x) + c(t)F(x)\big)\phi_E(t,x), \qquad (1)$$

where x is pixel position (not necessarily only in readout direction), t is the time, E is the echo/contrast index, $W(x)$ the water signal, $F(x)$ the fat signal, $c(t)$ the fat dephasing and $\phi_E(t,x)$ the phase evolution/error.

Thus, in Eq. 1, E indices multiple MRI echo images $S_E(x,t)$ that are acquired for multiple echo times using a measurement protocol, each one of the multiple MRI images including a contrast that is associated with the water spin species, as well as the fat spin species.

Based on the signal model of Eq. 1, a target function of an optimization can be formulated to determine the water image and the fat image based on the respective, a priori unknown, signal contributions $W(x)$ and F(x). The optimization finds extreme values of the target function.

Next, it will be described how to arrive at this target function starting from Eq. 1.

First, the phase maps $\phi_E(t,x)$ for each echo time is assumed to be known. Thus, generally, the target function of the optimization can take into account a predetermined phase map of the reference phase impacting the MRI echo images.

There are various options available for determining the phase maps, i.e., initializing the phase maps. For example, the conventional Dixon technique relies on the fact that these phase maps are spatially and temporally smooth and therefore boundary effects are not critical. Thus, the phase maps $\phi_E(t,x)$ can be determined using a further optimization such as used in conventional Dixon processing that neglects the effects of the sampling trajectory on the dephasing of the water signal with respect to the fat signal.

It is, in some examples, possible to update the phase maps taking into account the chemical-shift corrected MRI water and fat images determined using the optimization; and then re-iterate the Dixon processing (or general the further optimization) and performing of the optimization; thereby the phase maps $\phi_E(t,x)$ can be iteratively re-determined using two different optimizations until convergence is achieved. This increases the overall accuracy of determining the MRI water and fat images.

Second, the (fat) dephasing can be calculated for each k-space position. Here, the general form of $c(t)$ is assumed to be known. The dephasing between water and fat components can be calculated based on a single-peak model for the various spin species: $c_{single-peak}(t) = e^{i\Delta\omega F\,t}$. Here, $\Delta\omega$ defines the frequency offset with respect to water, e.g., for water - fat -3.4 ppm multiplied with Larmor frequency. Also, multi-peak models exist to better consider the chemical components of fat.

Specifically, the dephasing can be calculated based on the sampling trajectory of the measurement protocol. This gives a k-space position for each point in time; specifically, for different k-space positions along a readout line, different points in time are obtained that are associated with different dephasing. Based on knowledge of the sampling trajectory of the acquisition, it is then possible - starting from Eq. 1 - to associate the position in the Fourier-transformed frequency domain (k-space) with a certain readout time t. The dephasing during each readout duration can be taken into account. Thus, for the purpose of calculating the dephasing of fat with respect to water - e.g., using the single-peak approximation outlined above - the MRI fat image F(x) can be transformed to Fourier domain and then the respective dephasing can be applied for each K-space position. Then, a back-transformation to image domain can be applied. Specifically, the polarity of the multiple readout gradients of a bipolar gradient-echo readout train of the measurement protocol can be taken into account. To reflect this, Eq. 1 can be rewritten. For example, absorbing the known $\phi_E(t,x)$ into the known $S_E(x,t)$ and shifting to vector notation, one obtains, based on Eq. 1:

$$\vec{S}_E = \vec{W} + \overleftrightarrow{U}^{-1}\overleftrightarrow{C}\overleftrightarrow{U}\vec{F}, \qquad (2)$$

for each one of the multiple MRI echo images, i.e., for E=1, 2, .... Here $\vec{U}$ is the Fourier transform from image to frequency domain and $\vec{U}^{-1}$ its inverse. Furthermore, $\vec{C}$ is a diagonal matrix (i.e., elementwise multiplication) with c(t) at the associated k-space position of the sampling trajectory: This means that the dephasing can be calculated based on the timepoint at which a respective k-space position is sampled. More generally, the dephasing of fat with respect to water is calculated in K-space (more specifically an "effective" k-space obtained from Fourier transform for single-coil acquisition, as explained above) and applied as correction to each K-space data point of the K-space representation of the MRI fat image. This implements the chemical shift correction.

Based on Eq. 2, an (image-only) data fidelity term for the post-processing task of calculating chemical-shift-corrected water and fat images by means of an optimization is

$$D(\vec{W},\vec{F}) = \sum_E \left\| \vec{S}_E - \vec{W} - \overleftrightarrow{U}^{-1}\overleftrightarrow{C}\overleftrightarrow{U}\vec{F} \right\|_2^2. \qquad (3)$$

A target function of the optimization can include this data fidelity term.

Various techniques are based on the finding that this data fidelity term is often ill-posed for some frequencies. For example, in the case of E=2 (e.g., conventional bipolar Dixon for water-fat separation) and chemical shifts having frequency offsets that exceed the frequency offset for frequency encoding associated with a single pixel of the MRI images, there is always a frequency where both MRI echo images have aligned water and fat signal components. Thus, an unambiguous inversion to solve Eq. 3 is not possible.

Thus, according to various examples, the target function of the optimization takes into account an image-based regularization operation .

For instance, the regularization operation could be implemented based on an l1-norm or an l2-norm of a wavelet transformation of the MRI water and fat images. Another example would be a total variation of the MRI water and fat images. Yet another example would be a Tikhonov regularization operator applied to the MRI water and fat images. It would also be possible to rely on an implementation of the regularization operation by a neural network algorithm, i.e., a so-called variational neural network algorithm. The variational neural network algorithm can be trained to provide the chemical shift correction on representative images. These ML-based approaches have the benefit that they keep the data fidelity as well as provide natural image impression.

Based on Eq. 3 and considering the regularization operation yields an overall target function of the optimization of:

$$D\big(\vec{W},\vec{F}\big) + \lambda\, R\big(\vec{W},\vec{F}\big), \qquad\qquad (4)$$

with a regularization strength $\lambda$ (can be parameterized manually) and the regularization operation $R(\vec{W},\vec{F})$.

Conventional optimizers can be used to determine $\vec{W}$ and $\vec{F}$. For example, a gradient descent iterative numerical optimization can be implemented.

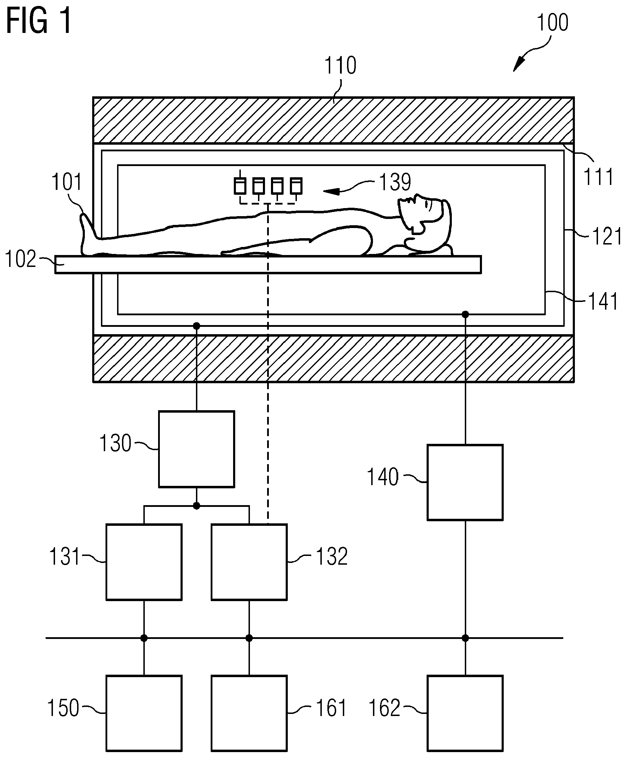

FIG. 1 depicts aspects with respect to an MRI device 100. The MRI device 100 includes a magnet 110, which defines a bore 111. The magnet 110 may provide a DC magnetic field of one to six Tesla along its longitudinal axis. The DC magnetic field may align the magnetization of the patient 101 along the longitudinal axis. The patient 101 may be moved into the bore by means of a movable table 102.

The MRI device 100 also includes a gradient system 140 for creating spatially-varying magnetic gradient fields (gradients) used for spatially encoding MRI data. Typically, the gradient system 140 includes at least three gradient coils 141 that are arranged orthogonal to each other and may be controlled individually. By applying gradient pulses to the gradient coils 141, it is possible to apply gradients along certain directions. The gradients may be used for slice selection (slice-selection gradients), frequency encoding (readout gradients), and phase encoding along one or more phase-encoding directions (phase-encoding gradients). The directions along which the various gradients are applied are not necessarily in parallel with the axes defined by the coils 141. Rather, it is possible that these directions are defined by a certain K-space trajectory - e.g., of a respective MRI measurement blade -, which, in turn, may be defined by certain requirements of the respective MRI sequence and/or based on anatomic properties of the patient 101. Gradients can also be used for forming gradient echoes. For instance, a gradient pulse train can be used that has gradients of opposing polarity.

For preparation and/or excitation of the magnetization polarized/aligned with the DC magnetic field, RF pulses may be applied. For this, an RF coil assembly 121 is provided which is capable of applying an RF pulse such as an inversion pulse or an excitation pulse or a refocusing pulse. While the inversion pulse generally inverts the direction of the longitudinal magnetization, excitation pulses may create transversal magnetization.

For creating such RF pulses, a RF transmitter 131 is connected via a RF switch 130 with the coil assembly 121. Via a RF receiver 132, it is possible to detect signals of the magnetization relaxing back into the relaxation position aligned with the DC magnetic field. In particular, it is possible to detect echoes; echoes may be formed by applying one or more RF pulses (spin echo) and/or by applying one or more gradients (gradient echo). The magnetization may inductively coupled with the coil assembly 121 for this purpose. Thereby, raw MRI data in K-space is acquired.

Generally, it would be possible to use separate coil assemblies for applying RF pulses on the one hand side and for acquiring MRI data on the other hand side (not shown in FIG. 1) .

The MRI device 100 further includes a human machine interface 150, e.g., a screen, a keyboard, a mouse, etc. By means of the human machine interface 150, a user input may be detected and output to the user may be implemented. For example, by means of the human machine interface 150, it is possible to set certain configuration parameters for the MRI sequences to be applied.

The MRI device 100 further includes a processing unit (simply processor) 161. The processor 161 may include a GPU and/or a CPU. The processor 161 may implement various control functionality with respect to the operation of the MRI device 100, e.g., based on program code loaded from a memory 162.

For example, the processor 161 could implement a sequence control for time-synchronized operation of the gradient system 140, the RF transmitter 131, and the RF receiver 132. The processor 161 may also be configured to implement an MRI reconstruction, i.e., implement post-processing for MRI reconstruction of MRI images based on MRI measurement datasets and separation of multiple spin species.

It is not required in all scenarios that processor 161 implements post-processing for reconstruction of the MRI images. In other examples, it would be possible that respective functionalities implemented by a separate device.

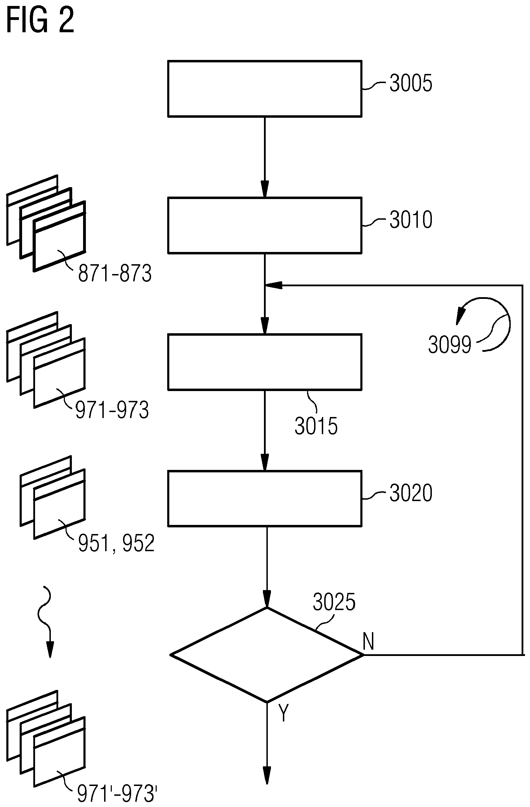

FIG. 2 is a flowchart of a method according to various examples. FIG. 2 schematically illustrates postprocessing for reconstruction of MRI images. For instance, the method of FIG. 2 could be implemented by the processor 161. It would also be possible that the method of FIG. 2 is implemented by a standalone device that is separate from the MRI device 100, e.g., by a PC including a processor that can load and execute program code from a memory. Cloud processing would be possible.

At box 3005, MRI data are acquired. A respective measurement protocol is employed. The measurement protocol can form gradient echoes using a bipolar gradient echo readout train.

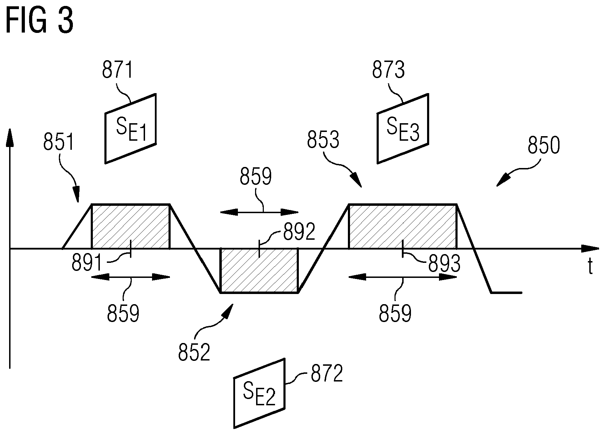

For instance, FIG. 3 schematically illustrates a bipolar gradient echo pulse train 850 including, in the illustrated example, two positive-polarity gradient pulses 851, 853; and a negative-polarity gradient pulse 852. Respective k-space lines are read out using the gradient pulses 851-853. I.e., different k-space points are sampled at different times during the readout durations 859. For each one of the echo times 891-893 a respective MRI echo image 871-873 is formed.

Now referring again to FIG. 2: Then, at box 3010, multiple MRI echo images 871-873 can be determined, for the different echo times. Conventional reconstruction techniques can be employed.

As a general rule, there can be a tendency to reduce the count of echo times, to reduce the overall measurement duration. For instance, it would be possible that the count of the multiple echo times is not larger than 2; and accordingly it would be possible that only two MRI echo images are determined.

At box 3015, phase maps 971-973 of the reference phase can be determined for each echo time. For this, a conventional Dixon processing can be employed. More generally, an optimization can be performed which uses a target function that is determined based on a signal model that neglects a dephasing of the multiple considered spin species with respect to each other for the various readout durations and echo times, due to an impact of the sampling trajectory of the measurement protocol.

Next, at box 3020, an optimization can be performed, wherein the optimization includes a target function that calculates, based on the sampling trajectory of the measurement protocol, the dephasing of the multiple spin species with respect to each other as a function of time. The target function of the optimization can further take into account an image-based regularization operation. Based on the optimization, MRI images that include a contrast that is selected for a respective spin species are determined. For instance, an MRI water image 951 and an MRI fat image 952 can be determined.

Using the regularization operation, the ill-posed nature of the data-fidelity time can be compensated for. Various regularization operations such as total variation, 11 or 12 norm of a wavelet transformation or Tikhonov regularization operator can be used. It would also be possible to use a pretrained variational neural network algorithm to implement the regularization operation.

It would be optionally possible, at box 3025, to check whether the phase maps 971'-973' of the reference phase determined based on the output of the optimization at box 3020 and the initial assumption of the phase map 971-973 determined at box 3015 deviate significantly. If convergence of the a priori estimate of the phase map and the a posteriori estimate of the phase map is not yet reached, box 3015 and box 3020 can be re-executed. Specifically, the further optimization of box 3015 can be re-performed based on the updated phase map of the reference phase obtained as a posteriori estimate from box 3020. Respective iterations 3099 can be implemented until convergence of the phase map obtained from the optimization at box 3015 and the optimization at box 3020.

Summarizing, techniques have been disclosed that include performing an optimization for determining MRI images resolving multiple spin species based on reconstructed MRI echo images obtained from a multi-shot MRI sequence. The optimization takes into account a result of a preceding further optimization, e.g., a conventional Dixon reconstruction; specifically, phase maps of a reference phase can be taken into account.

Furthermore, the optimization employs a target function that is calculated based on the sampling trajectory, i.e., the K-space trajectory; based on the K-space trajectory it is possible to conclude on the time at which a certain data sample is acquired. Thereby, a phase offset between the multiple spin species can be determined, e.g., based on - in a simple case test the duration and polarity of readout gradients of a readout gradient echo train.

The target function of the optimization can include a regularization operation operating in the image domain, to regularize the potentially ill-posed inversion of the data fidelity term derived from the signal model.

Techniques have been disclosed that facilitate iterating the proposed chemical shift correction and conventional Dixon water-fat separation to achieve a joint optimization of the chemical shift and phase maps.

The regularization operation could be implemented using a variational neural network algorithm. Such variational neural network algorithm could be trained based on training data that can be generated using reference measurements.

Although the invention has been shown and described with respect to certain preferred embodiments, equivalents and modifications will occur to others skilled in the art upon the reading and understanding of the specification. The present invention includes all such equivalents and modifications and is limited only by the scope of the appended claims.

For illustration, above scenarios have been disclosed in which the measurement protocol employs a gradient-echo readout train and the impact on chemical shift has been discussed. Similar impact is observed for non-Cartesian sampling patterns of K-space and it is possible to implement the techniques described herein by considering respective sampling trajectories and considering, in the target function of the optimization, the dephasing of the spin species with respect to each other at respective readout time points defined by the non-Cartesian sampling trajectories.

For further illustration, above, water and fat separation has been used as an example to illustrate techniques for separation of arbitrary spin species.

**Claims**

1. A computer-implemented method for determining a first magnetic-resonance imaging, MRI, image (951) having a first contrast associated with a first spin species and a second MRI image (952) having a second contrast associated with a second spin species, wherein the method comprises:

    - obtaining multiple MRI images (871-873) acquired for multiple echo times (891-893) using a measurement protocol, each one of the multiple MRI images (871-873) comprising a contrast associated with both the first spin species and the second spin species, and
    - based on the multiple MRI images (871-873), performing an optimization to determine the first MRI image (951) for the first spin species and the second MRI image (952) for the second spin species, the optimization comprising a target function that calculates, based on a sampling trajectory of the measurement protocol, a dephasing of the second spin species with respect to the first spin species as a function of time,

    wherein the target function of the optimization further takes into account an image-based regularization operation.

2. The computer-implemented method of claim 1,
   wherein the image-based regularization is based on an l1-norm or an l2-norm of a wavelet transformation of the first MRI image and the second MRI image, or a total variation of the first MRI image and the second MRI image, or comprises a Tikhonov regularization operator applied to the first MRI image and the second MRI image.

3. The computer-implemented method of claim 1,
   wherein the image-based regularization is implemented using a pretrained variational neural network algorithm

4. The computer-implemented method of any one of the preceding claims,
   wherein the target function of the optimization takes into account predetermined phase maps (971-973) of a reference phase for each one of the multiple echo times (891-893).

5. The computer-implemented method of claim 4, further comprising:

    - initializing the phase maps by a further optimization that neglects the dephasing of the second spin species with respect to the first spin species calculated based on the sampling trajectory, and
    - executing multiple iterations (3099), each one of the multiple iterations (3099) comprising a sequence of the following steps:

        - said performing of the optimization for the MRI images of the spin species,
        - updating the phase map based on a result of the optimization, and
        - performing the further optimization based on the updated phase map.

6. The computer-implemented method of any one of the preceding claims,
   wherein the dephasing is calculated based on a single-peak model of the second spin species.

7. The computer-implemented method of any one of the preceding claims,
   wherein the dephasing is calculated based on a polarity of multiple readout gradients (851-853) of a bipolar gradient-echo readout train (850) of the measurement protocol.

8. The computer-implemented method of any one of the preceding claims,

    wherein the measurement protocol comprises a bipolar gradient-echo readout train (850),
    wherein the target function of the optimization takes into account the dephasing of the second spin species with respect to the first spin species as a function of time during each one of multiple readout gradients (851-853) of the bipolar gradient-echo readout train (853).

9. The computer-implemented method of any one of the preceding claims,
   wherein a count of the multiple echo times (891-893) is not larger than 2.

10. The computer-implemented method of any one of the preceding claims,
    wherein the dephasing of the second spin species with respect to the first spin species is calculated in k-space and applied as correction to each k-space point of a k-space representation of the second MRI image.

11. A computer program comprising program code for determining a first magnetic-resonance imaging, MRI, image (951) having a first contrast associated with a first spin species and a second MRI image (952) having a second contrast associated with a second spin species, the program code causing a processor that executes the program code to:

    - obtain multiple MRI images (871-873) acquired for multiple echo times (891-893) using a measurement protocol, each one of the multiple MRI images (871-873) comprising a contrast associated with both the first spin species and the second spin species, and
    - based on the multiple MRI images (871-873), perform an optimization to determine the first MRI image (951) for the first spin species and the second MRI image (952) for the second spin species, the optimization comprising a target function that calculates, based on a sampling trajectory of the measurement protocol, a dephasing of the second spin species with respect to the first spin species as a function of time,

    wherein the target function of the optimization further takes into account an image-based regularization operation.

12. The computer program of claim 11,
    wherein the program code causes the processor to perform a method of any one of claims 1 to 10.

13. A device comprising a processor and a memory, the processor being configured to load program code from the memory and execute the program code, wherein the program code is for determining a first magnetic-resonance imaging, MRI, image (951) having a first contrast associated with a first spin species and a second MRI image (952) having a second contrast associated with a second spin species, the program code causing the processor that executes the program code to

    - obtain multiple MRI images (871-873) acquired for multiple echo times (891-893) using a measurement protocol, each one of the multiple MRI images (871-873) comprising a contrast associated with both the first spin species and the second spin species, and
    - based on the multiple MRI images (871-873), perform an optimization to determine the first MRI image (951) for the first spin species and the second MRI image (952) for the second spin species, the optimization comprising a target function that calculates, based on a sampling trajectory of the measurement protocol, a dephasing of the second spin species with respect to the first spin species as a function of time,

    wherein the target function of the optimization further takes into account an image-based regularization operation.

14. The device of claim 13,
    wherein the program code causes the processor to perform a method of any one of claims 1 to 10.

FIG 1

FIG 2

# FIG 3

EUROPEAN SEARCH REPORT

Application Number

EP 21 21 4552

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | THOMAS BENKERT ET AL: "Free-breathing volumetric fat/water separation by combining radial sampling, compressed sensing, and parallel imaging", MAGNETIC RESONANCE IN MEDICINE, vol. 78, no. 2, 9 September 2016 (2016-09-09), pages 565-576, XP055493625, US ISSN: 0740-3194, DOI: 10.1002/mrm.26392 * second paragraph on page 566, sub-section "Dixon-RAVE: Optimization Problem and Signal Model" of section "THEORY" on page 566, sub-section "Reconstruction Implementation" on page 567, first paragraph on page 568, first whole paragraph on page 572; figure 1 * | 1-14 | INV. G01R33/48 G01R33/56 G01R33/565 ADD. G06N3/02 |

-----

-/--

TECHNICAL FIELDS SEARCHED (IPC)

G01R
G06N

The present search report has been drawn up for all claims

| Place of search | Date of completion of the search | Examiner |
|---|---|---|
| Munich | 19 May 2022 | Lebar, Andrija |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | BENKERT THOMAS ET AL: "Comprehensive Dynamic Contrast-Enhanced 3D Magnetic Resonance Imaging of the Breast With Fat/Water Separation and High Spatiotemporal Resolution Using Radial Sampling, Compressed Sensing, and Parallel Imaging", INVESTIGATIVE RADIOLOGY, vol. 52, no. 10, 1 October 2017 (2017-10-01), pages 583-589, XP055922870, US ISSN: 0020-9996, DOI: 10.1097/RLI.0000000000000375 Retrieved from the Internet: URL:https://www.ncbi.nlm.nih.gov/pmc/articles/PMC5585043/pdf/nihms860210.pdf> * abstract, last two paragraphs on page 2, pages 3 and 4, last paragraph on page 7 * ----- | 1-14 | |
| | | | **TECHNICAL FIELDS SEARCHED (IPC)** |

The present search report has been drawn up for all claims

| Place of search | Date of completion of the search | Examiner |
|---|---|---|
| Munich | 19 May 2022 | Lebar, Andrija |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 102013217654 A1
- US 2020049783 A
- US 7777486 B2
- US 8605967 B2

**Non-patent literature cited in the description**

- **X. ZHONG ; M. D. NICKEL ; S. A. KANNENGIESSER ; B. M. DALE ; B. KIEFER ; M. R. BASHIR.** Liver fat quantication using a multi-step adaptive fitting approach with multi-echo GRE imaging. *Magn. Reson. Med.,* 2014, vol. 72 (5), 1353-1365